Europäisches Patentamt

European Patent Office

Office européen des brevets

(11) Publication number: 0 253 174
A1

## (12) EUROPEAN PATENT APPLICATION

(21) Application number: 87109210.2

(22) Date of filing: 26.06.87

(51) Int. Cl.4: H01L 29/205 , H01L 29/76 , H01L 31/02 , H01S 3/19 , G02F 1/015

(30) Priority: 18.07.86 US 888181

(43) Date of publication of application:
20.01.88 Bulletin 88/03

(84) Designated Contracting States:
DE FR GB IT

(71) Applicant: International Business Machines Corporation
Old Orchard Road
Armonk, N.Y. 10504(US)

(72) Inventor: Chang, Leroy Li-Gong
Manor Drive P. O. Box 548
Goldens Bridge, N.Y.10526(US)

(74) Representative: Mönig, Anton, Dipl.-Ing.
IBM Deutschland GmbH Schönaicher
Strasse 220
D-7030 Böblingen(DE)

(54) Resonant tunneling semiconductor devices.

(57) This disclosure relates to resonant tunneling semiconductor devices useful for transport functions such as switching or amplification, and also for electro-optical conversions. In the structure of these devices, a central potential well (10) is formed of an opposite conductivity type of semiconductor material to two semiconductor layers (12) outside resonant tunneling barriers (14) on each side of the central potential well, such that electrons in the well can tunnel to and from the outside semiconductor layers. The central potential well serves as the base of a three terminal device in transport applications, and as the light responsive portion for electro-optical applications. In one disclosed embodiment, the device is constructed in five layers of the most commonly used gallium-aluminium-arsenide compounds, an n GaAs substrate, undoped GaAlAs, p GaAs, undoped GaAlAs, and n GaAs.

FIG.1

## RESONANT TUNNELING SEMICONDUCTOR DEVICES

Technical Field

The present invention relates generally to resonant tunneling semiconductor devices which are useful in transport applications such as in switching and amplification, and are also useful in electro-optical applications such as in laser generation and photodetection.

More particularly, the subject invention pertains to resonant tunneling semiconductor devices in which a central potential well is formed of an opposite conductivity semiconductor type to the layer outside the resonant tunneling barriers. The central potential well serves as the base of a three terminal device in transport applications, and as the radiation responsive or radiation generating portion of an electro-optical device in electro-optical applications.

Background Art

Three terminal semiconductor devices have been conceptualized since the observation of resonant tunneling through a quantum well between two barriers. However, conventional thinking, dealing only with electrons, encounters difficulties both conceptually in devising useful structures and technically in contacting the central, thin quantum well.

The principle of resonant tunneling through barriers has been described in Applied Phys. Lett., Vol. 24, No. l2, l5 June l974. Briefly, this publication describes the observation of resonant tunneling of electrons in double-barrier structures having a thin GaAs layer sandwiched between two GaAlAs barriers. The resonance manifests itself as peaks in the tunneling current at voltages near the quasistationary states of the potential well. The structures are fabricated by molecular beam epitaxy which produces extremely smooth films and interfaces.

Copeland, III et al U.S. Patent 4,438,447 is somewhat pertinent to the present invention only to the extent that is discloses a vertical multilayer electro-optical structure. In greater detail, this patent discloses an electro-optic integrated circuit wherein the long electrical connections normally present on a large scale integrated circuit are replaced by an optical waveguide layer. A plurality of epitaxial layers are grown on a single substrate, and at least three of the plurality of epitaxial layers are grown with bandgaps that are suitable for optical sources, detectors and waveguides. These primary layers are separated from each other by a barrier layer having a bandgap greater than either of the adjacent primary layers. Two of the layers adjacent to the substrate are grown to accommodate electrical devices that can be used to couple electrical signals to the optical source layers, and to amplify electrical signals provided by the optical detection layer.

However, the prior art described hereinabove does not disclose or teach electron transport perpendicular to the layers, in particular resonant tunneling semiconductor structures of the present invention.

Summary of the Invention

Accordingly, it is a primary object of the present invention to provide semiconductor devices operating on the principle of resonant tunneling which utilize a central potential well with opposite conductivity type to that of the two external layers outside the barriers.

A further object of the subject invention is the provision of three terminal resonant tunneling semiconductor devices useful for transport applications and also for electro-optical conversion applications.

In accordance with the teachings herein, the present invention provides resonant tunneling semiconductor devices constructed with first and second layers of like conductivity semiconductor crystal separated by first and second barriers of semiconductor crystal having therebetween a quantum well of opposite conductivity semiconductor crystal, such that conduction occurs by tunneling serially through the first and second barriers.

One problem associated with structures of this nature is the provision of an electrical contact extending to the quantum well, and the present invention provides a novel solution for this problem by forming the contact of the same type of conductivity semiconductor material as the central potential well. The contact is therefore of an opposite type of semiconductor material to the layers of semiconductor cyrstal outside the first and second barriers, such that electrical conductivity therebetween is prevented. This approach thereby allows the contact to physically contact either one or both of the layers of semiconductor material without establishing an electrical current path thereto.

The first and second layers of like conductivity semiconductor crystal can be either n or p type semiconductor crystal, as long as the quantum well is the opposite p or n of semiconductor crystal.

In one disclosed embodiment with the most commonly used gallium-aluminum-arsenide compounds, the first and second layers are n GaAs semiconductor crystal, the first and second barriers are undoped GaAlAs semiconductor crystal, and the quantum well is a p GaAs semiconductor crystal.

The resonant tunneling device can be used for transport switching functions, wherein the first and second layers of like conductivity semiconductor crystal form the collector and emitter, and the quantum well forms the base, such that when a voltage applied to the base equals a threshold voltage, the device becomes conductive to provide for electrical conduction between the emitter and the collector. The resonant tunneling device can also be used for transport amplification functions wherein the voltage applied to the base determines the amplification function between the emitter and the collector.

The resonant tunneling device can also be used for electro-optical detection functions wherein the amount of radiation incident on the quantum well determines the current flow between the first and the second layers of like conductivity semiconductor crystal, or for electro-optical lasing functions wherein the amount of radiation emitted by the quantum well is determined by the relative voltages of the first and second layers of like conductivity semiconductor crystal.

Brief Description of the Drawings

The foregoing objects and advantages of the present invention for resonant tunneling semiconductor devices may be more readily understood by one skilled in the art with reference being had to the following detailed description of several preferred embodiments thereof, taken in conjunction with the accompanying drawings wherein like elements are designated by identical reference numerals throughout the several views, and in which:

Figure I illustrates an exemplary embodiment of a resonant tunneling semiconductor device constructed pursuant to the teachings of the present invention and illustrates the different crystal structures and associated energy levels therein;

Figure 2 illustrates a resonant tunneling semiconductor device functioning in a transport switching application;

Figure 3 illustrates a family of curves for a resonant tunneling semiconductor device of the same type as illustrated in Figures I and 2, which enable it to function in a transport amplification application with different base voltage levels;

Figure 4 is a schematic illustration of a resonant tunneling semiconductor device functioning in an electro-optical lasing application;

Figure 5 is a schematic illustration of a resonant tunneling semiconductor device functioning in an electro-optical detection application; and

Figure 6 illustrates a preferred embodiment of a contact extending to the quantum potential well of a resonant tunneling semiconductor device constructed pursuant to the teachings of the subject invention.

Description of the Preferred Embodiments

The present invention concerns semiconductor devices which are generally three terminal devices based on the phenomenon of resonant tunneling. These devices are constructed from epitaxial layers of proper materials with suitable thickness and doping, such that the structures can be utilized to perform a variety of functions for transport and optoelectronics under different operational conditions. Applications for high speed switching or amplification and for efficient light emission and detection are particularly of interest.

Referring to an exemplary embodiment in Figure I, a central region I0 in which a semiconductor potential well is located is formed of an opposite conductivity type to the semiconductor layers I2 located outside of two resonant tunneling barriers I4, such that electrons can tunnel through the barriers I4. In transport applications, the central potential well serves as the base of a three terminal device, and in electro-optical applications the central potential well serves as the light responsive or light lasing portion. In the embodiment illustrated in Figure I, the device is constructed in five layers, n GaAs, undoped GaAlAs, p GaAs, undoped GaAlAs, n GaAs, between an n GaAs substrate I6 and an outer surface I8, with reachthrough contacts (not shown) being provided to the p GaAs base and the n GaAs emitter.

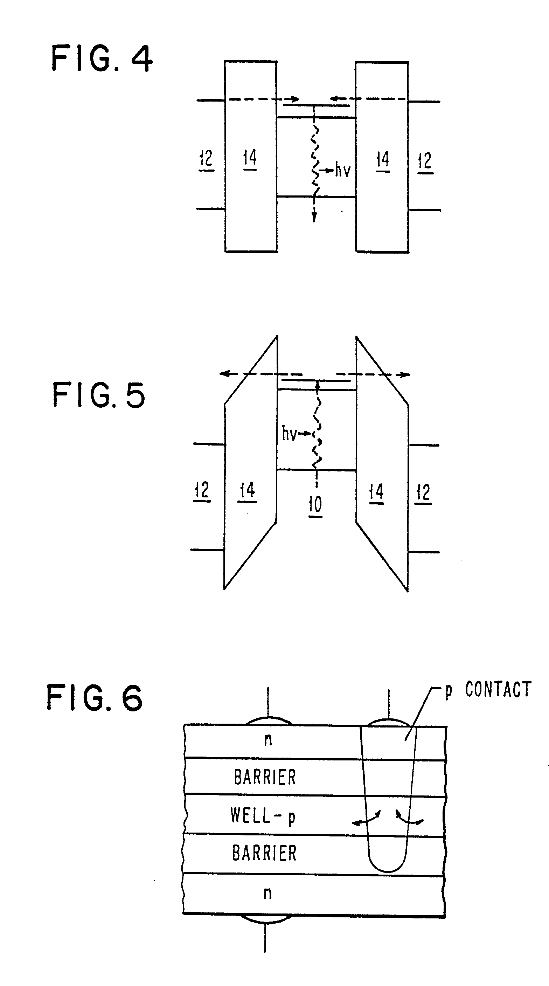

In the structure of Figure I, the well is p-type with composition xl (x refers the alloy composition of Al in GaAlAs) and width dl; the outside layers are n-type with composition x2 and width d2, and the barriers are undoped with composition x3 and width d3. The requirements are $xl < x2 < x3$, and dl, d3 of the order of 50Å. The widths d2 are not critical. The n-contacts can be made in a conventional way to the x2 layer on the surface and from the n-substrate I6 on which the entire structure is grown, for example by molecular beam epitaxy. The p-layer I0 can be contacted by selective etching based on the type of conductivity or by alloying through the surface to form a contact of the same type semiconductor material as the quantum well, as explained in greater detail hereinbelow with reference to Figure 6.

The essence of resonant tunneling lies in the formation of quasi-stationary quantum states in the well at specific energies, depending on the details of the configuration (x, d, etc.). Typically, the lowest energy state is l0-l00 meV with similar spacings between the states since more than one such state can generally be formed. This is shown in Fig. I by horizontal lines for both electron and hole states, only the former, however, are of interest here. The quantum states provide an effective channnel of electron tunneling between the barriers. At these energies, an intensive electron wave is built inside the well so that a small leakage outside will result in nearly perfect transmission. On the other hand, at other energies (even with a single barrier), there is virtually no transmission.

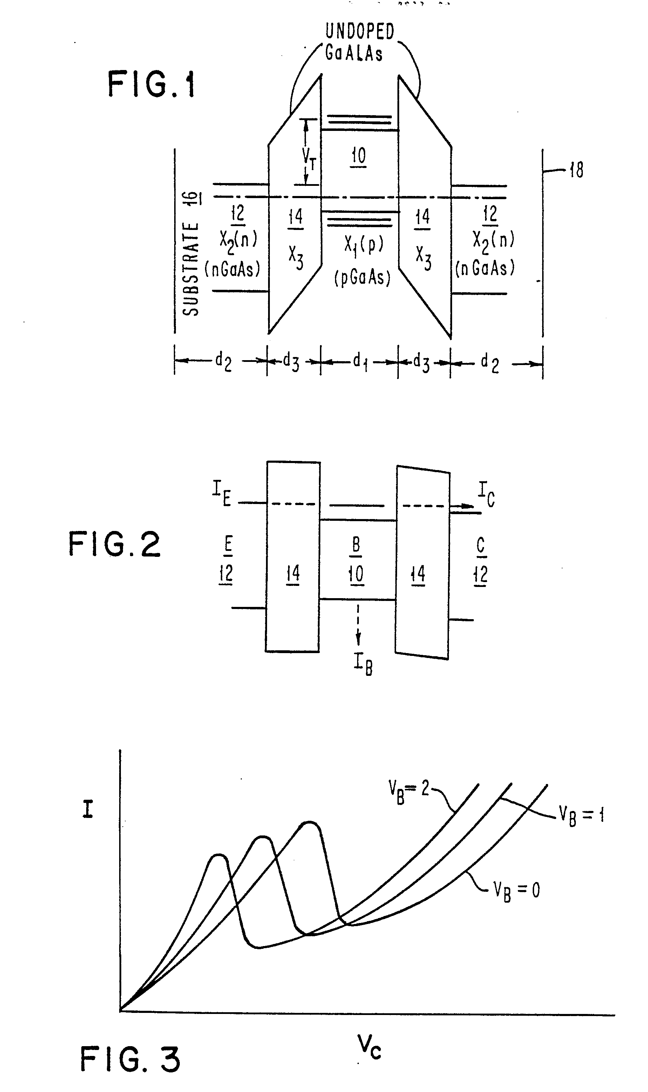

Referring to Figure 2, the electrodes are designated as the emitter E, the collector C, and the base B. In operation, when a voltage applied to the base equals a threshold voltage VT(Figure I), the device becomes conductive to provide for electrical conduction between the emitter and the collector. For switching operations, we note that no appreciable current flows initially until VB = VT, the threshold voltage, when the device is sharply turned on. (Fig. 2). For this purpose, VE = O and VC is slightly positive to provide states for tunneling. Since the tunneling times is much shorter than the recombination time, IC≈IE for nearly unit gain, and the base draws little current but operates as an effective gate.

Figure 3 illustrates a family of curves for a resonant tunneling semiconductor device of the same type as illustrated in Figure I and 2. Here the resonant condition is reached by applying a voltage Vc. The current-voltage characteristic is governed by different base voltage levels (designated 0, I, 2). The highly nonlinear current-voltage behavior, including a negative resistance, makes these structures capable of functioning not only as a flexible switching device but also as an amplifier or an oscillator.

For optoelectronic applications, the emitter and collector are biased at the same value, say VE = VC = O, and VB>VT. Figure 4 is a schematic illustration of a resonant tunneling semiconductor device functioning in an electro-optical emission application. As shown in Figure 4, electrons flow into the well where they are trapped, and an intense wave is built up. Strong radiative recombination with holes occurs, leading to light emitting and lasing actions. The reverse of this situation make the device an effective detector (Fig. 5).

Electrons generated in the well tunnel rapidly to the outside electrodes, where external circuitry is used for sensitive detection. The application of bias voltage is optional in this case.

For operation of these devices, the penetration (or traversal) time is estimated to be very short, tt = $(m/2E)^{1/2} \cdot d3$ where m is the electron mass and E is the electron energy. This is calculated to be smaller than $10^{-14}$ sec, which poses no serious limit for continuous operation. The limiting time for switching is expectedly the storage time or the time for the electron wave to build up or decay. It is given by $\tau c/T$ where $\tau_v^{-1}$ is the frequency the electron wave striking the barrier and T is the transmission at resonance. Typically, it is about $10^{-12}$ sec. The delay (or charging) time is not significant in comparison. An estimate from $g_m^{-1}$ C gives $10^{-13}$ sec, where C is the capacitance and $g_m = \Delta J/\Delta v$ where $\Delta J$ is the current change at resonance and $\Delta v$ is the width in resonant energy (hT/$\tau o$, h being Planck's constant). The various characteristic times are much shorter than the recombination time, which is usually in the nanosecond to sub-nanosecond range.

More than one quantum level is usually present. The operations can be tuned to each level if required. In other cases, a flat response at V>VT may be desirable. This can be achieved by designing the structure with close level spacings and asymmetrical barriers.

Complementary structures with n-well and p-outside layers are equally operable, as well as the use of multiple wells and superlattices instead of the single well. Also, different semiconductors can be used rather than alloys with different compositions. Indeed, combinations, such as InAs and GaSb are ideal in that their band schemes closely resemble those shown in Figure I without considering the space-charge effect which has been neglected. A general requirement is that the barrier material has the larger energy gap through which the carriers tunnel, and the well material has the smallest gap to fascilitate contact formation and light absorption.

Figure 6 illustrates a preferred embodiment of a contact extending to the quantum potential well of a resonant tunneling semiconductor device pursuant to the subject invention. One problem associated with structures of this nature is the provision of an electrical contact extending to the quantum well, and the present invention provides a novel solution for this problem by forming the contact of the same type of conductivity semiconductor material as the central potential well. The contact is therefore of an opposite type of semiconductor material to the layers of semiconductor crystal outside the first and second barriers, such that electrical conductivity therebetween is prevented. Accordingly, this approach allows the contact to physically contact either one or both of the layers of opposite semiconductor material without establishing an electrical current path thereto.

While several embodiments and variations of the present invention for resonant tunneling semiconductor devices are described in detail herein, it should be apparent that the disclosure and teaching of the present invention will suggest many alternative designs to those skilled in the art.

## Claims

1. A resonant tunneling semiconductor device, comprising first and second layers (12) of like conductivity semiconductor crystals separated by first and second barriers (14) of semiconductor crystal having therebetween a quantum well (10) of opposite conductivity semiconductor crystal, such that conduction occurs by tunneling serially through the first and second barriers.

2. A resonant tunneling semiconductor device as claimed in claim 1, wherein an electrical contact extends to the quantum well, and is formed by an opposite conductivity semiconductor material.

3. A resonant tunneling semiconductor device as claimed in claims 1 or 2, wherein the first and second layers (12) of like conductivity semiconductor crystals are n type semiconductor crystal, and the quantum well (10) is a p type semiconductor crystal.

4. A resonant tunneling semiconductor device as claimed in one of the preceding claims, wherein the first and second layer of n type semiconductor crystal are n GaAs, the first and second barrier of semiconductor crystal are undoped GaAlAs, and the quantum well is a p GaAs semiconductor crystal.

5. A resonant tunneling semiconductor device as claimed in one of the preceding claims, wherein the first and second layer of like conductivity semiconductor crystal are p type semiconductor crystals, and the quantum well is an n type semiconductor crystal.

6. A resonant tunneling semiconductor device as claimed in one of claims 1 to 5, wherein the resonant tunneling device has a transport switching function wherein the first and second layers of like conductivity semiconductor crystal are the collector and emitter, and the quantum well is the base, wherein when the voltage applied to the base equals a threshold voltage, the device becomes conductive to provide for electrical conduction between the emitter and the collector (Fig. 2).

7. A resonant tunneling semiconductor device as claimed in one of claims 1 to 5, wherein the resonant tunneling device has a transport amplification function wherein the first and second layers of like conductivity semiconductor crystal are the collector and emitter, and the quantum well is the base, wherein when the voltage applied to the base determines the amplification function between the emitter and the collector (Fig. 3).

8. A resonant tunneling semiconductor device as claimed in one of claims 1 to 5, wherein the resonant tunneling device has an electro-optic detection function wherein the amount of radiation incident on the quantum well determines the current flow between the first and second layers of like conductivity semiconductor crystal (Fig. 5).

9. A resonant tunneling semiconductor device as claimed in one of claims 1 to 5, wherein the resonant tunneling device has an elecro-optic lasing function wherein the amount of radiation emitted by the quantum well is determined by the voltages of the first and second layers of like conductivity semiconductor crystal relative to said quantum well (Fig. 4).

# FIG.1

UNDOPED
GaALAs

$V_T$

$\underline{10}$

18

SUBSTRATE $\underline{16}$

$\underline{12}$
$X_2(n)$
$(nGaAs)$

$\underline{14}$
$X_3$

$X_1(p)$
$(pGaAs)$

$\underline{14}$
$X_3$

$\underline{12}$
$X_2(n)$
$(nGaAs)$

$d_2$ — $d_3$ — $d_1$ — $d_3$ — $d_2$

# FIG.2

$I_E$

$I_C$

$\underline{E}$
$\underline{12}$

$\underline{14}$

$\underline{B}$
$\underline{10}$

$\underline{14}$

$\underline{C}$
$\underline{12}$

$I_B$

$I$

$V_B = 2$

$V_B = 1$

$V_B = 0$

$V_C$

# FIG. 3

IBM — YO 986 002

# FIG. 4

# FIG. 5

# FIG. 6

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | IBM TECHNICAL DISCLOSURE BULLETIN, vol. 27, no. 5, October 1984, pages 3053-3056, New York, US; B. RICCO et al.: "Tunable resonant tunnelling semiconductor emitter structure" * Whole document * | 1-6 | H 01 L 29/205 <br> H 01 L 29/76 <br> H 01 L 31/02 <br> H 01 S 3/19 <br> G 02 F 1/015 |
| A | IDEM | 7-9 | |
| | --- | | |
| X | EP-A-0 159 273 (FUJITSU LTD) * Page 4, line 23 - page 15, line 8; page 22, table; figures * | 1,3-7 | |
| A | | 8,9 | |
| | --- | | **TECHNICAL FIELDS SEARCHED (Int. Cl.4)** |
| A | RADIO FERNSEHEN ELEKTRONIK, vol. 28, no. 2, February 1979, pages 71-75, Berlin, DE; J. FRAHM et al.: "Der Halbleiterinjektionslaser und seine Anwendung - Teil 1: Grundlagen" * Page 72, figure 2 * | 8,9 | H 01 L <br> G 02 F <br> H 01 S |
| | --- | | |
| A | US-A-4 208 667 (CHANG et al.) * Whole document * | 8,9 | |
| | ----- | | |

The present search report has been drawn up for all claims

| Place of search | Date of completion of the search | Examiner |
|---|---|---|
| THE HAGUE | 08-09-1987 | MORVAN D.L.D. |